# EUROPÄISCHE PATENTSCHRIFT

(11) **EP 3 824 702 B1**
(45) Veröffentlichungstag und Bekanntmachung des Hinweises auf die Patenterteilung: **17.07.2024**
(21) Anmeldenummer: 19733940.1
(22) Anmeldetag: 23.05.2019
(51) Int. Cl.: H05K 7/20, H05K 7/14

(54) **LEISTUNGSBAUGRUPPE MIT TRAGENDEM KÜHLKÖRPER**
POWER ASSEMBLY HAVING A LOAD-BEARING COOLING BODY
MODULE DE PUISSANCE À DISSIPATEUR THERMIQUE PORTEUR

(30) Priorität: 25.05.2018 AT 504302018
(43) Veröffentlichungstag der Anmeldung: 26.05.2021
(73) Patentinhaber: Miba Energy Holding GmbH, 4663 Laakirchen (AT)
(72) Erfinder: NAGELMÜLLER, Martin, 4650 Edt bei Lambach (AT); RATZI, Raimund, 4600 Wels (AT)
(74) Vertreter: Burger, Hannes
(86) Internationale Anmeldenummer: PCT/AT2019/060172
(87) Internationale Veröffentlichungsnummer: WO 2019/222781

(56) Entgegenhaltungen:
- EP-A1- 2 701 477
- CN-A- 106 452 105
- DE-U1- 29 813 254
- JP-A- 2012 105 419
- JP-A- 2014 011 926
- US-A1- 2005 002 162
- US-A1- 2008 130 223
- US-A1- 2009 091 897
- US-A1- 2010 321 896
- US-A1- 2016 128 240

## Beschreibung

Die Erfindung betrifft eine Leistungsbaugruppe für einen Mittel- oder Hochspannungsumrichter, vorzugsweise einen Modularen Multilevel Umrichter, welche eine als tragendes Element ausgebildete zentrale Kühlplatte zur Aufnahme von zumindest Energiespeicher- und Leistungshalbleiterbaugruppen umfasst.

Moderne Mittel- oder Hochspannungsumrichter weisen in der Regel eine Mehrzahl von miteinander verschalteten Leistungsbaugruppen zum Umrichten einer Wechsel- in eine Gleichspannung oder umgekehrt auf. Derartige Leistungsbaugruppen können auch als Submodule, speziell bei Modularen Multilevel Umrichtern, bezeichnet werden. Dabei sind dem Fachmann eine Vielzahl von möglichen Anordnungen von Energiespeicherbaugruppen, Leistungshalbleiterbaugruppen, damit verbundene Steuervorrichtungen und insbesondere zur Kühlung dieser Elemente vorgesehene Kühlvorrichtungen bekannt.

In der WO2008/074274A1 ist ein Multilevel-Stromrichter mit einer Mehrzahl von Leistungshalbleiter aufweisenden Stromrichtermodulen und einer Mehrzahl von Energiespeichern offenbart, wobei zumindest ein Stromrichtermodul an einem Energiespeicher tragend befestigt ist. Zur Ausbildung des Modularen Multilevel Umrichters werden derartige Multilevel-Stromrichter in einem Gestell derart angeordnet, dass der Energiespeicher auf Querstreben des Gestells an seiner Front- und Rückseite abgestützt ist, wodurch die Zugänglichkeit für einen schnellen Austausch einer Leistungsbaugruppe erschwert wird. Bei einer derartigen Anordnung sind zur Kontaktierung der Anschlüsse für Strom-, Steuerung- und/oder Kühlmittel teils relativ lange Verbindungselemente bzw. -leitungen erforderlich, welche nutzerseitig eine Beeinträchtigung der Zugänglichkeit mit sich bringen.

In der US2017194878A1 wird ein möglicher Aufbau für eine Leistungsbaugruppe bzw. Submodul eines Multilevel-Stromrichters offenbart, welcher die Anordnung einer Leistungshalbleiterbaugruppe der Leistungsbaugruppe zumindest teilweise direkt auf einer Kühlplatte vorsieht. Zur Montage einer derartigen Leistungsbaugruppe in einem Multilevel-Stromrichters ist jedoch eine relativ aufwändige Rahmenkonstruktion zur Halterung der einzelnen Komponenten der Leistungsbaugruppe erforderlich um eine Lastabtragung auf ein Gestell eines Multilevel-Stromumrichters zu ermöglichen. Des Weiteren weist die offenbarte Konstruktion den Nachteil auf, dass die Energiespeichereinheit in Vertikalrichtung auf der Halbleitereinheit angeordnet ist, wodurch die Kühlwirkung der Kühlplatte auf die Energiespeichereinheit reduziert wird.

Die EP1125355B1 offenbart eine Stromrichter-Kondensatorbaugruppe, welche als tragende Komponente ausgebildet ist. Die Kondensatoren sind oberhalb von Leistungshalbleitern montiert, wodurch der Nachteil einer reduzierten Wärmeableitung des entfernt von den Kondensatoren angeordneten Kühlkörpers in Kauf genommen werden muss.

Die US 2016/128240 A1 offenbart ein Kühlströmungskanalmodul für eine Leistungsumwandlungsvorrichtung, bei dem eine Struktur eines Kühlströmungskanals zum Kühlen einer Leistungsumwandlungsvorrichtung einschließlich eines Wechselrichters oder eines LDC vorgesehen ist. Die US 2009/091897 A1 offenbart elektrische Energieumwandlungsvorrichtungen und universelle Einhausungen dieser Vorrichtungen für verschiedene Anwendungen. In CN 106 452 105 A ist eine Vorrichtung aus einem Schrankkörper, einem im Schrankkörper angeordneten Hauptsteuermodul und mehreren parallel zueinander geschalteten Hochfrequenz-Gleichrichtungsgeräten gezeigt. Die US 2010/321896 A1 offenbart eine elektrische Leistungskomponente, die an einem Chassis einer elektrischen Leistungsvorrichtung angebracht ist, einschließlich eines Halbleiterelements, das eine elektronische Schaltung bildet und einer Kühleinheit, die das Halbleiterelement kühlt und als Verstärkungsmaterial zur Erhöhung der Festigkeit des Chassis dient. EP 2 701 477 A1 offenbart ein Gehäuse für ein elektronisches Gerät, welches eine Gehäusewand, umfassend ein dielektrisches Material, eine erste leitende Schicht, die an einer Innenfläche der Gehäusewand anliegt, und eine zweite leitende Schicht, die an einer Außenfläche anliegt, umfasst. Die DE 298 13 254 U1 zeigt einen mehrphasigen Dreipunkt-Stromrichter mit mehreren vertikal verlaufenden Phasenbausteinen die räumlich nebeneinander in einer Raumkonstruktion angeordnet sind.

Die US 2005/002162 A1 offenbart eine Vielzahl denkbarer Konfigurationen modularer Leistungswandler mit einem thermischen Träger zur Ableitung von Wärme aus den Kreisläufen. Gemäß eines Ausführungsbeispiels können modulare Einheiten zusammengebaut werden, die über Steckanordnungen oder über eine Schnittstelle mit einer Rückwandplatine oder ähnlichen Montage- und Verbindungsstrukturen mit elektronischen Schaltkreisen verbunden werden können. Der thermische Träger kann dabei eine Vielzahl von Sicherungsmitteln oder Pads aufweisen. Mittels der Pads kann der thermische Träger innerhalb eines Gehäuses befestigt bzw. gesichert werden.

Die US 2008/130223 A1, die JP 2014 011926 A und die JP 2012 105419 A beschreiben jeweils eine elektronische Leistungsbaugruppe, welche in einem Elektrofahrzeug oder in einem Hybridfahrzeug eingebaut ist. Eine Kühlplatte dieser Baugruppe weist vertikal verlaufende Durchbrüche auf, durch welche Leitungsverbindungen zwischen einer Kondensatoreinheit und einem Halbleitermodul hindurchgeführt sind.

Dem Fachmann sind weitere Anordnungen für Leistungsbaugruppen bekannt, in welchen die Energiespeicherbaugruppe in Längsrichtung hinter der Halbleiter- und/oder Steuerbaugruppe angeordnet ist. Vorrangig ist dabei die größte Längenausdehnung einer Leistungsbaugruppe in Vertikalrichtung ausgebildet, wodurch sich mehrere Leistungsbaugruppen in einem Gestell zur Bildung eines modularen Umrichters neben- und übereinander anordnen lassen, jedoch eine relativ große Bauhöhe in Kauf genommen werden muss.

Die zunehmenden Anforderungen an die Sicherheit, insbesondere Explosionsschutz und Bedienersicherheit, gehen mit der Forderung einer kostengünstigen Fertigung der Leistungsbaugruppe einher. Des Weiteren ist eine schnelle und komfortable Austauschbarkeit einer Leistungsbaugruppe im Schadensfall wünschenswert. Außerdem wäre eine individuelle Anpassbarkeit einer Leistungsbaugruppe an die jeweiligen, lokalen Erfordernisse eines Mittel- oder Hochspannungsumrichters an stationären Anlagen wünschenswert, oder auch für den Einsatz an beweglichen Aufstellungsorten, wie etwa einem Zug oder Schiff, von praktischem Vorteil.

Aufgabe der vorliegenden Erfindung war es, die Nachteile des Standes der Technik zu überwinden und eine Leistungsbaugruppe zur Verfügung zu stellen, welches eine einfache, kostengünstige, sichere und schnell austauschbare Plattformlösung darstellt.

Diese Aufgabe wird durch eine Vorrichtung gemäß den Ansprüchen gelöst.

Die erfindungsgemäße Leistungsbaugruppe für einen Mittel- oder Hochspannungsumrichter, vorzugsweise einen Modularen Multilevel Umrichter, umfasst, zumindest eine Leistungshalbleiterbaugruppe, zumindest eine Energiespeicherbaugruppe und zumindest eine Kühlvorrichtung. Die Kühlvorrichtung ist dabei als, von einem Kühlmittel durchströmbare, Kühlplatte ausgebildet, woran an einer Oberseite der Kühlplatte die zumindest eine Leistungshalbleiterbaugruppe und an einer Unterseite der Kühlplatte die zumindest eine Energiespeicherbaugruppe angeordnet sind, und wobei die zumindest eine Leistungshalbleiterbaugruppe mit der Kühlplatte thermisch leitfähig verbunden ist. Die Kühlplatte weist zur lastübertragenden Abstützung auf einem Gestell des Mittel- oder Hochspannungsumrichters in Querrichtung gegenüber zumindest einer Energiespeicherbreite der Energiespeicherbaugruppe hervorragende Stützflächen auf. Eine derartige Leistungsbaugruppe ist bevorzugt innerhalb eines dafür vorgesehenen Aufnahmeraums des Gestells des Mittel- oder Hochspannungsumrichters angeordnet, wobei das Gestell in Querrichtung beliebig erweitert werden kann.

Die Leistungshalbleiterbaugruppe umfasst, vorzugsweise eine IGBT-Baugruppe, MOSFETs, Transistoren oder dergleichen. Die Energiespeicherbaugruppe umfasst vorzugsweise eine Kondensatorbaugruppe, welche eine Mehrzahl von Kondensatoren umfassen kann, und/oder andere zweckdienliche Energiespeicher. Die Verbindung der einzelnen Komponenten mittels geeigneter Leitungselemente, wie einer Stromschiene oder dergleichen, ist dem Fachmann hinreichend bekannt und wird daher nicht näher erläutert. Eine Steuervorrichtung zur Steuerung der Leistungsbaugruppe kann an der Ober- oder Unterseite der Kühlplatte angeordnet sein.

Durch die erfinderische Ausbildung des Kühlkörpers als lastabtragendes Konstruktionselement, wird gleichzeitig eine Stützfunktion der Leistungsbaugruppe am Gestell ausgeübt und eine Aufnahmeplattform für sämtliche am Kühlkörper angeordneten Baugruppen gebildet. Die Kühlplatte dient somit als eine Art Aufbauplatte zur Aufnahme der Energie-, Leistungshalbleiterbaugruppen und etwaiger weiterer Komponenten. Derartige Komponenten können z.B. in Form einer Hilfsbaugruppe an der Kühlplatte angeordnet sein und etwa eine Steuervorrichtung, Netzteile, Widerstände und dergleichen umfassen. Je nach Aufbau und Typ des Mittel- oder Hochspannungsumrichters ist es dabei von Vorteil, zumindest eine Leistungshalbleiterbaugruppe an der Oberseite der Kühlplatte anzuordnen und die zumindest eine Energiespeicherbaugruppe an der gegenüberliegenden Seite, nämlich der Unterseite, der Kühlplatte anzuordnen. Weitere Anordnungen, mit jeweils zumindest teilweise an der Ober- und Unterseite der Kühlplatte angeordneten Komponenten liegen im Gestaltungsfreiraum des Konstrukteurs und können ebenfalls mit der erfindungsgemäßen Plattformanordnung an der Kühlplatte realisiert werden. Es ist in jedem Fall von großem Vorteil, dass die Kühlplatte zentral derart angeordnet ist, dass die abgegebene Wärme zumindest der Energie- und Leistungshalbleiterbaugruppe effizient abgeführt werden kann.

Ferner kann durch die Ausbildung der Kühlvorrichtung als kühlmitteldurchströmte Kühlplatte eine Reduktion der Abmessungen der Leistungsbaugruppe gegenüber z.B. Luftkühlvornchtungen gleichen Wirkungsgrades realisiert werden. Als Kühlmittel wird hierbei eine Kühlflüssigkeit besonders bevorzugt. Hierdurch wird insbesondere eine "flache", bevorzugt liegende, Anordnung der Leistungsbaugruppe ermöglicht. Dies begünstigt die Gestaltung eines Mitteloder Hochspannungsumrichters mit vergleichsweise geringen Gesamtabmessungen, da mehrere Leistungsbaugruppen in den dafür vorgesehenen Aufnahmeräumen übereinander angeordnet sein können. Speziell im Vergleich zu "stehenden" Leistungsbaugruppen bekannter Bauweise, bei denen die Energie- und Leistungshalbleiterbaugruppen in Längsrichtung des Aufnahmeraums und in Vertikalrichtung die Breite der Leistungsbaugruppe in Querrichtung deutlich überragen, kann somit eine Verringerung des Platzbedarfs erreicht werden.

Als weiterer Vorteil der gegenwärtigen Erfindungslösung ist die gute Zugänglichkeit der Leistungsbaugruppe von der Frontseite zu erwähnen, da die Kühlplatte seitlich an den Stützflächen auf dafür vorgesehenen Tragelementen des Gestells aufliegt, und somit eine frontseitige Querstrebe vermieden werden kann. Hierdurch wird dem Bediener ein sehr schnelles und einfach zugängliches Auswechseln der Leistungsbaugruppe im Schadensfall ermöglicht und etwaige frontseitige Anschlüsse der Leistungsbaugruppe sind sehr gut zugänglich.

Des Weiteren ist es zweckmäßig, dass die zumindest eine Leistungshalbleiterbaugruppe an der Oberseite und die zumindest eine Energiespeicherbaugruppe an der Unterseite der Kühlplatte angeordnet sind.

Leistungsbaugruppen weisen in der Regel ein sehr hohes Eigengewicht von mehr als 200 kg auf. Den Großteil des Gesamtgewichts macht hierbei die Energiespeicherbaugruppe aus. Durch diese vorteilhafte Anordnung der Energiespeicherbaugruppe an der Unterseite wird ein sehr niedriger Schwerpunkt der Leistungsbaugruppe erreicht. Dies vermeidet im Vergleich zu bekannten Anordnungen ein unerwünschtes Kippmoment und erhöht auf diese Weise die Benutzersicherheit. Zudem kann durch die zentrale Anordnung der Energiespeicherbaugruppe an der Unterseite der Kühlplatte eine im Wesentlichen mechanisch spannungsfreie elektrische Anbindung der Energiespeicherbaugruppe an die Leistungshalbleiterbaugruppe durch die Kühlplatte ausgebildet werden. Dabei kann eine kontrollierte, zulässige Ausdehnung der Energiespeicherbaugruppe in Vertikalrichtung nach unten sowie in Querrichtung seitlich bei thermischer Wechselbelastung ermöglicht werden. Dieses Phänomen ist als "Atmen" eines Kondensators bekannt. Auf diese Weise wird die Funktionalität der Leistungshalbleiterbaugruppe für einen längeren Zeitraum gewährleistet, da eine unerwünschte Relativbewegung von etwaigen Kontakten zwischen der Energiespeichergruppe zur Leistungshalbleitergruppe vermieden werden kann.

Ferner kann vorgesehen sein, dass die Kühlplatte derart ausgebildet ist, dass eine Kühlplattenlänge in Längsrichtung zur Kühlplattenbreite in Querrichtung ein Verhältnis von 5:1 bis 1:2, insbesondere von 2:1 bis 1:1 aufweist und dabei jeweils größer als eine Leistungsbaugruppenhöhe in Vertikalrichtung ist.

Die Ausbildung der Kühlplatte in den angegebenen Dimensionen erlaubt eine "flache" Ausbildung der Leistungsbaugruppe. Durch die geringe Leistungsbaugruppenhöhe in Vertikalrichtung kann ein Verkippen der Leistungsbaugruppe bei einem Wechselvorgang vermieden werden, da der Schwerpunkt der Leistungsbaugruppe relativ tief gelagert ist. Durch die bevorzugt in Längsrichtung eine Querrichtung überragende ausgebildete Kühlplatte wird außerdem eine besonders gute Lastverteilung auf das Gestell des Mittel- oder Hochspannungsumrichters gewährleistet. Ein weiterer Vorteil liegt darin, dass eine sehr kompakte Bauweise der jeweiligen Leistungsbaugruppen zu einer geringen Gesamtabmessung des Mittel- oder Hochspannungsumrichters führt.

Darüber hinaus kann vorgesehen sein, dass die Kühlplatte in Längsrichtung an einer Rückseite zumindest über einen Teil der Kühlplattenbreite gegenüber einer Energiespeicherlänge hervorragend ausgebildet ist.

Gemäß dieser Ausführungsform kann die als Aufbauplattform dienende Kühlplatte zur verbesserten Auflage und zusätzlichen Abstützung auf einem rückseitig angeordneten Querelement des Gestells verwendet werden. Diese einfache und kostengünstige Maßnahme bietet weiters den Vorteil, dass für unterschiedliche Ausbildungsformen einer Leistungsbaugruppe unterschiedliche Energiespeicherbaugruppengrößen, wie etwa durch unterschiedliche Kondensatoranzahl, mittels einer standardisierten Kühlplatte realisiert werden können.

Vorteilhaft ist auch eine Ausprägung gemäß welcher vorgesehen sein kann, dass an der Kühlplatte rückseitig zumindest ein mit einer Koppelvorrichtung des Gestells korrespondierendes, bevorzugt als Stift mit Nut oder Stift mit gegenüber einem Stiftdurchmesser verbreiterten Kopf ausgebildetes, Rückhalteelement angeordnet ist.

Eine derartige Koppelvorrichtung ist vorzugsweise am oder innerhalb eines Querelements des Gestells angeordnet und kann beispielsweise als Aufnahmekörper oder Lasche ausgebildet sein. Das Koppelelement kann dabei eine Aufnahmeöffnung, wie etwa eine Längsnut, aufweisen, welche formkomplementär zum korrespondierenden Rückhalteelement der Kühlplatte ausgebildet ist. Bei einem Wechsel der Leistungsbaugruppe wird die Leistungsbaugruppe in eine Servicestellung gebracht, wobei die Stützflächen der Kühlplatte in Vertikalrichtung über den Tragelementen des Gestells angehoben werden. In dieser Servicestellung kann die Leistungsbaugruppe in das Gestell in den dafür vorgesehenen Aufnahmeraum eingeführt werden, wobei das Rückhalteelement beispielsweise als Zentrierhilfe dienen kann und gleichzeitig einen Endanschlag in Längsrichtung in Richtung Gestell bildet. Beim Absenken der Leistungsbaugruppe aus der Servicestellung in die Ruhestellung greift das stiftförmige Rückhalteelement mittels einer Nut und/oder einem Kopf in die korrespondierende Aufnahmeöffnung der Koppelvorrichtung ein, wodurch eine Arretierung der Leistungsbaugruppe am Gestell sichergestellt ist. Ein Stift mit Nut oder Stift mit gegenüber einem Stiftdurchmesser verbreitertem Kopf hat sich als besonders vorteilhaft erwiesen. Eine derartige Koppelvorrichtung vermeidet somit eine separate Sicherung der Leistungsbaugruppe gegen Herausfallen aus dem Gestell und ist kostengünstig und durch die selbsttätige Arretierung äußerst sicher ausgeführt.

Erfindungsgemäß weist die Kühlplatte zumindest eine Anschlussöffnung in Vertikalrichtung zur Durchführung und Kontaktierung von Stromanschlüssen der Energiespeicherbaugruppe zur Leistungshalbleiterbaugruppe und/oder Steuervorrichtung auf.

Die Verbindung der Energiespeicherbaugruppe kann beispielsweise als Klemmen an einem Anschlussblock zentral in Quer- und/oder Längsrichtung der Kühlplatte erfolgen. Dies ermöglicht, dass sämtliche stromführenden Leitungen innerhalb der Leistungsbaugruppe verlaufend angeordnet werden können. Weiters bietet die zentrale Anordnung eines derartigen Anschlussblocks bzw. Anschlussterminals und die Durchführung durch eine Anschlussöffnung in der Kühlplatte in der Mitte die Möglichkeit parasitäre Induktivitäten des Energiespeichers effektiv zu reduzieren.

Ferner weist die Leistungsbaugruppe zumindest ein Oberseitengehäuse zur Aufnahme der Leistungshalbleiterbaugruppe und/oder der Steuervorrichtung und zumindest ein Unterseitengehäuse zur Aufnahme der Energiespeicherbaugruppe auf, welche mit der Kühlplatte befestigbar, bevorzugt koppelbar, ausgebildet sind.

Das Oberseiten- und/oder Unterseitengehäuse kann als Abdeckung der Leistungsbaugruppe verstanden werden. Im Hinblick auf einen geeigneten Explosionsschutz für benachbart angeordnete Leistungsbaugruppen ist hierbei vorteilhaft, wenn ein Oberseiten- und/oder Unterseitengehäuse keine Öffnungen außer allenfalls erforderlicher Anschlussöffnungen für Stromanschlüsse und/oder Steueranschlüsse aufweist. Im Servicefall ist es jedoch vorteilhaft, wenn ein Ober- und/oder Unterseitengehäuse möglichst einfach und rasch entfern- bzw. wiederanbringbar ist. Im einfachsten Fall wird dies durch eine Mehrzahl von Schraubverbindungen realisiert.

Darüber hinaus kann vorgesehen sein, dass die Torsionssteifigkeit der Kühlplatte um eine horizontale Torsionsachse höher als die Torsionssteifigkeit des Oberseitengehäuses und/oder des Unterseitengehäuses ist.

Bei der Fertigung eines Ober- und/oder Unterseitengehäuses kann es zu einem Verzug, wie etwa Schweißverzug, des Gehäuses kommen. Derartige Gehäuse können eine sehr hohe Quer- bzw. Biegesteifigkeit aufweisen, wodurch bei einer Befestigung des Ober- und/oder Unterseitengehäuses an der Kühlplatte ein Verzug der Kühlplatte eintreten könnte. Um eine optimale Abstützung der Leistungsbaugruppe am Gestell zu ermöglichen, ist es vorteilhaft die Kühlplatte derart auszulegen, dass ihre Torsionssteifigkeit jene des Ober- und/oder Unterseitengehäuses übersteigt. Dem Fachmann ist überlassen konstruktive, steifigkeitsverbessernde Maßnahmen vorzunehmen, welche neben der Optimierung der Kühlplattenstärke auch das Vorsehen allenfalls erforderlicher Versteifungselemente an der Kühlplatte oder ähnliche geeignete Maßnahmen umfassen können. Eine Übertragung eines möglicherweise durch Schweißen des Gehäuses auftretenden Verzugs auf die Kühlplatte kann somit vermieden werden.

Des Weiteren kann vorgesehen sein, dass zumindest das Unterseitengehäuse zur Erhöhung der Torsionssteifigkeit der Leistungsbaugruppe ein an der Kühlplatte flächig anliegendes Deckelelement aufweist, wobei das Unterseitengehäuse mit der Kühlplatte an einer Mehrzahl von Befestigungsstellen verbunden ist.

In Ergänzung zu den zuvor genannten Ausführungsformen eines Unterseitengehäuses kann es vorteilhaft sein, dass das Unterseitengehäuse im Wesentlichen als geschlossene Box mit Ausnahme einer Anschlussöffnung ausgebildet ist. Insbesondere wenn das Unterseitengehäuse zur Aufnahme der Energiespeichereinheit verwendet wird, ist eine stabile Ausbildung des Unterseitengehäuses vorteilhaft. Die Eigensteifigkeit des Untergehäuses kann vorteilhafterweise dazu genutzt werden, eine Erhöhung der Steifigkeit, insbesondere der Torsionssteifigkeit, der Kühlplatte zu bewirken. Hierfür ist es erforderlich, dass das Deckelelement des Untergehäuses möglichst großflächig an der Unterseite der Kühlplatte anliegt. Auf diese Weise übt das Deckelelement durch den direkten Kontakt mit der Kühlplatte die gleiche Funktion in Richtung Inneres des Unterseitengehäuses aus. Das Deckelelement kann somit als Teil der Kühlplatte verstanden werden. Um eine geeignete Anbindung des Deckelelements an der Kühlplatte zu gewährleisten, ist es vorteilhaft, mehrfache Verschraubungen an Befestigungsstellen durchzuführen. Durch eine derartige spaltfreie Verschraubung des Deckelelements wird ein guter Wärmeübergang zur Kühlplatte gewährleistet. Ebenso kann zur Verbesserung des Wärmeübergangs ein Zwischenmedium, wie etwa ein "Gap-Pad" und/oder Wärmeleitpaste, zwischen der Kühlplatte und dem als Teil der Kühlplatte fungierenden Deckelelement vorgesehen sein.

Gemäß einer besonderen Ausprägung ist es möglich, dass das Unterseitengehäuse, insbesondere das Deckelelement, kühlplattenseitig in Querrichtung relativ zur Energiespeicherbreite hervorragende, insbesondere bis zur Kühlplattenbreite hervorragende, Vorsprünge aufweist. Es hat sich in gewissen Fällen als vorteilhaft erwiesen, die Befestigung des Untergehäuses über seitlich am Untergehäuse hervorragende Vorsprünge an der Kühlplatte vorzunehmen. Diese Vorsprünge können neben der Befestigungseigenschaft den Vorteil aufweisen, dass sie als Zwischenelement zur Auflage der Leistungsbaugruppe bzw. der Kühlplatte am Gestell dienen. Auf diese Weise kann ein Teil des Lastabtrags vom Deckelelement des Untergehäuses ausgeübt werden. Neben einer Erhöhung der Steifigkeit der Leistungsbaugruppe kann ein zusätzlicher Effekt genutzt werden, welcher durch eine veränderte Materialpaarung an der Kontaktfläche der Leistungsbaugruppe zum Gestell bewirkt wird. Im Falle eines Aluminiumkühlkörpers kann die Korrosionsanfälligkeit gegenüber einem Tragelement aus Stahl dadurch verringert werden, dass das Unterseitengehäuse bzw. die Vorsprünge, welche zur Auflage am Tragelement des Gestells benutzt werden, ebenfalls aus Stahl ausgebildet sind.

Entsprechend einer vorteilhaften Weiterbildung kann vorgesehen sein, dass an der Stützfläche der Kühlplatte und/oder des Unterseitengehäuses gegenüber dem Gestell des Mittel- oder Hochspannungsumrichters ein, vorzugsweise aus einem vom Material der Kühlplatte und/oder des Unterseitengehäuses abweichendem Material hergestelltes, Zwischenelement vorgesehen ist.

Durch diese Maßnahme können unerwünschte Korrosionsphänomene zwischen der Kühlplatte und dem Gestell vermieden werden. Ein weiterer Vorteil liegt darin, dass ein derartig ausgebildetes Zwischenelement zur Aufnahme und Dämpfung von Schwingungen des Gestells dienen kann. Hierfür kommen vor allem elektrisch nichtleitende Materialien mit geeigneten Schwingungsdämpfungseigenschaften in Frage. Bei der Umsetzung haben sich vor allem leistenförmige Zwischenelemente aus einem synthetischen Kunststoff oder GFK bewährt.

Insbesondere kann es vorteilhaft sein, wenn jeweils zumindest zwei Stromanschlüsse und/oder Steueranschlüsse und/oder etwaige Mess- bzw. Hilfsanschlüsse und/oder bevorzugt als Schnellverschlüsse ausgebildete Kühlmittelanschlüsse an einer Frontseite der Leistungsbaugruppe ausgebildet sind.

Durch diese Maßnahme wird eine sehr gute Zugänglichkeit zu sämtlichen Anschlüssen der Leistungsbaugruppe gewährleistet. Eine einfache, schnelle und sichere An- bzw. Abkopplung der Anschlüsse kann dadurch erreicht werden. Überdies fördert diese Maßnahme den Explosionsschutz, da sämtliche Anschlussöffnungen der Leistungsbaugruppe lediglich an der Frontseite angeordnet sind.

Darüber hinaus kann vorgesehen sein, dass die zumindest zwei, bevorzugt als Schnellverschlüsse ausgebildete, Kühlmittelanschlüsse zur Kopplung an einen Kühlmittelkreislauf des Mittel- oder Hochspannungsumrichters an der Frontseite der Kühlplatte frei zugänglich angeordnet sind.

Die erfindungsgemäße Ausbildung der Leistungsbaugruppe ermöglicht die Anordnung der Kühlmittelanschlüsse an der Frontseite der Kühlplatte, wodurch sie einfach zugänglich für einen Bediener sind. Bevorzugt sind die Kühlmittelanschlüsse als Schnellverschlüsse ausgebildet, wodurch ein selbsttätiges Abdichten beim Abkoppeln des Kühlmittelanschlusses erfolgt. Auf diese Weise kann ein unbeabsichtigter Kühlmittelaustritt vermieden werden. Überdies sind derartige Schnellverschlüsse einfach zu bedienen.

Vorteilhaft ist auch eine Ausprägung gemäß welcher vorgesehen sein kann, dass die Kühlmittelanschlüsse derart ausgebildet sind, dass jeweils zumindest ein Anschlussabschnitt in Vertikalrichtung nach unten weisend ausgebildet ist.

Durch eine derartige Ausbildung der Kühlmittelanschlüsse wird ermöglicht, dass eine selbsttätige Kopplung der Kühlmittelanschlüsse mit den korrespondierenden Gegenstücken eines Kühlmittelkreislaufs des Mittel- oder Hochspannungsumrichters beim Absenken in Vertikalrichtung erfolgen kann. Diese Art einer selbsttätigen Kopplung ist schnell und einfach sowie besonders sicher und vermeidet eine Fehlbedienung eines Bedieners. Es kann dabei eine Ausführung gewählt werden, welche eine selbsttätige Entkopplung beim Anheben der Leistungsbaugruppe erlaubt, wodurch die Sicherheit und Schnelligkeit beim Wechselvorgang deutlich erhöht werden können.

Ferner kann vorgesehen sein, dass an der Stirnseite der Kühlplatte in Querrichtung zumindest ein über die Kühlplattenbreite hervorragendes Anschlagelement angeordnet ist.

Ein derartiges Anschlagelement kann mit der Kühlplatte starr verbunden sein und dient somit als Tiefenanschlag in Längsrichtung der Leistungsbaugruppe beim Einführen in einen Aufnahmeraum des Gestells des Mittel- oder Hochspannungsumrichters. Bevorzugt wird eine paarweise, beidseitige Anordnung derartiger Anschlagelemente. Hierdurch kann eine sichere und schnelle sowie einfache Möglichkeit für eine korrekte Positionierung der Leistungsbaugruppe im Gestell gewährleistet werden. Ein weiterer Vorteil liegt darin, dass sämtliche Leistungsbaugruppen in Vertikalrichtung in einer Ebene ausgerichtet sind, wodurch sämtliche Anschlüsse und hierbei insbesondere die Stromanschlüsse, in einer Ebene ausgerichtet sind. Auf diese Weise wird bei einer Verschaltung der Leistungsbaugruppen untereinander eine mechanische Verspannung der Anschlussleisten zwischen den Stromanschlüssen vermieden.

Gemäß einer Weiterbildung ist es möglich, dass die Kühlplatte aus zumindest zwei in Längsrichtung und/oder Querrichtung und/oder Vertikalrichtung geteilten, Kühlplattensegmenten zur Ausbildung eines durchgehenden Kühlkanals zusammengesetzt ist.

Eine Ausbildung der Kühlplatte durch Zusammensetzen mehrerer Kühlplattensegmente ermöglicht eine einfache modulare Bauweise der Kühlplatte, wodurch entsprechend des Plattformgedankens der vorliegenden Erfindung eine einfache bedarfsgemäße Anpassung an die Anordnung der Leistungshalbleiterbaugruppe und/oder der Energiespeicherbaugruppe an der Kühlplatte vorgenommen werden kann. Im einfachsten Fall kann durch Zusammenfügen von zwei horizontal geteilten Kühlplattensegmenten eine Kühlplatte gebildet sein, wobei zumindest ein Kühlplattensegment eine Ausnehmung für einen Kühlkanal aufweist. Die Kühlplattensegmente können miteinander durch geeignete Verbindungselemente verbunden sein. Auch Lötverbindungen sind hierbei denkbar. Zur Erhöhung der Festigkeit können die Kühlplattensegmente mittels einer Schweißverbindung verbunden sein. Insbesondere bei Kühlplatten aus Aluminium oder Aluminiumlegierungen hat sich eine Verbindung der Kühlplattensegmente zueinander mittels Rührreibschweißens bewährt.

Ferner kann es zweckmäßig sein, wenn zumindest zwei Kühlplattensegmente voneinander unterschiedliche Kühlleistungen aufweisen.

Auf diese Weise wird es möglich, eine Optimierung der lokalen Wärmeabfuhr durch die Kühlplatte vorzunehmen. Die zuvor beschriebenen Maßnahmen erlauben somit eine lokale Anpassung der Wärmeabfuhrleistung entsprechend der vorgebbaren Anordnung von insbesondere Leistungshalbleitern und/oder Energiespeicher an der Kühlplatte. Außerdem kann eine derartige Ausbildung der Kühlplatte zu einem kostengünstigen Design führen.

Darüber hinaus kann vorgesehen sein, dass zumindest ein Kühlplattensegment, zur Ausbildung eines durchgehenden Kühlkanals in zusammengesetztem Zustand der Kühlplatte, eine Kühlkanalausnehmung zur Aufnahme einer formkomplementären Kühlmittelleitung aufweist, welche in zusammengesetztem Zustand der Kühlplatte von der Kühlplatte eingeschlossen ist.

In gewissen Fällen kann es vorteilhaft sein, wenn eine separate Kühlmittelleitung vorgesehen ist, welche innerhalb der Kühlplatte angeordnet ist. Zur Aufnahme einer derartigen Kühlmittelleitung kann auf einfache Weise zumindest ein Kühlplattensegment an zumindest einer Seite, beispielsweise durch Ausfräsen einer Kühlkanalausnehmung, vorbearbeitet werden. Diese Maßnahme kann insbesondere vorteilhaft sein, wenn mehrere Kühlplattensegmente miteinander verbunden werden, da der gemeinsam ausgebildete Kühlkanal durch die innenliegende Kühlmittelleitung auf jeden Fall vor Kühlmittelverlust geschützt ist. Die Kühlmittelleitung kann zu einer Verbesserung der Wärmeleitung, beispielsweise aus Kupfer ausgebildet sein oder, zur Vermeidung von Korrosionsphänomenen gegenüber einer Kühlplatte aus Aluminium, auch zum Beispiel aus einem korrosionsbeständigen Stahl. Zur Verbesserung des Wärmeübergangs der Kühlmittelleitung ist es vorteilhaft, diese durch eine Lötverbindung mit der Kühlplatte zu verbinden. Ebenso kann die Ausbildung einer Kühlmittelleitung vorteilhaft sein, wenn ein Kühlmittel, insbesondere eine Kühlflüssigkeit, verwendet wird, welche mit dem Material der Kühlplatte zu Korrosionsproblemen führen würde. Beispielhaft sei eine Kombination von deionisiertem Wasser mit Aluminium angeführt, welche durch den Einsatz eines korrosionsbeständigen Stahls als Kühlmittelleitung zur Vermeidung der genannten Probleme führen kann.

Zum besseren Verständnis der Erfindung wird diese anhand der nachfolgenden Figuren näher erläutert.

Es zeigen jeweils in stark vereinfachter, schematischer Darstellung:
- Fig. 1: schematische Schrägansicht eines Teils eines Mittel- oder Hochspannungsumrichters mit drei übereinander angeordneten Leistungsbaugruppen;
- Fig. 2: schematische Schrägansicht eines Ausführungsbeispiels einer Leistungsbaugruppe mit lastabtragender Kühlplatte;
- Fig. 3: beispielhafte Darstellung eines Ausführungsbeispiels einer Kühlplatte aus mehreren Kühlplattensegmenten (a), und einer Explosionsdarstellung zweier Kühlplattensegmenten mit Kühlmittelleitung (b);
- Fig. 4: schematische Schrägansicht der Rückseite des Gestells mit Leistungsbaugruppe und Koppelvorrichtung (a), sowie des Prinzips der Zentrierung und/oder Arretierung (b);
- Fig. 5: schematische Schrägansicht eines Teils eines Mittel- oder Hochspannungsumrichters mit gekoppeltem Kühlmittelkreislauf (a), und eines Ausführungsbeispiels zur selbsttätigen Kopplung (b).

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

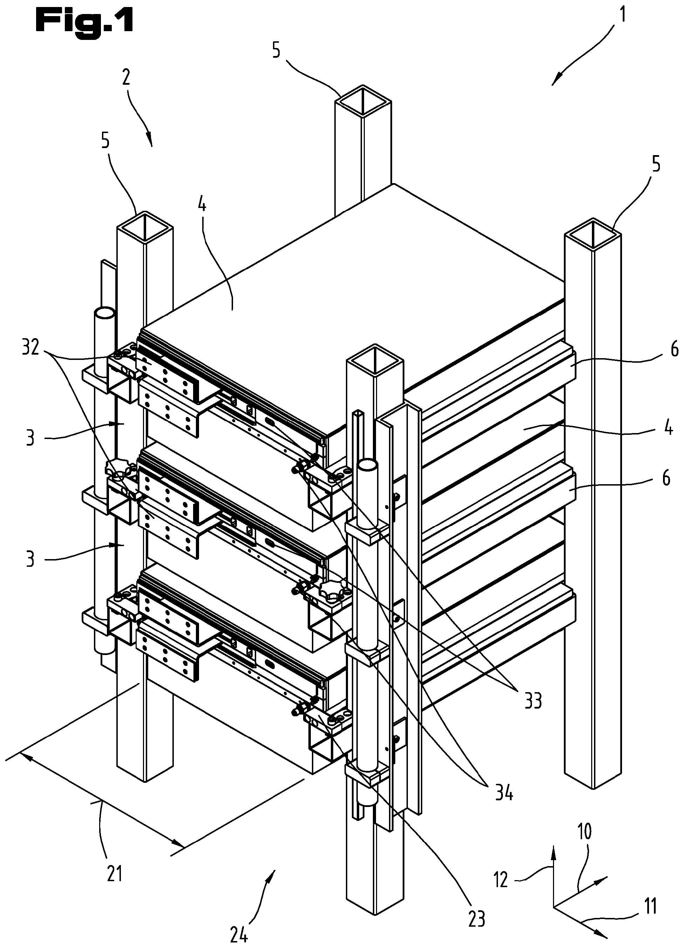

In Fig. 1 ist ein Beispiel für einen Mittel- oder Hochspannungsumrichter 1 dargestellt. Ein derartiger Mittel- oder Hochspannungsumrichter 1 weist ein Gestell 2 auf in welchem mehrere übereinander angeordnete Aufnahmeräume 3 zur Aufnahme von jeweils einer Leistungsbaugruppe 4 ausgebildet sind. Ein Mittel- oder Hochspannungsumrichter 1 kann mehrere derartige Gestelle 2 und somit eine Vielzahl von Leistungsbaugruppen 4 aufweisen. Das Gestell 2 umfasst dabei Vertikalstehelemente 5, welche jeweils paarweise angeordnet sind und mittels horizontal ausgerichteter Tragelemente 6 verbunden sind. An der Rückseite 25 des Gestells 2 können die Tragelemente 6 mittels Querelementen 8 verbunden sein. Durch die Verbindung von Tragelementen 6 und einem Querelement 8 wird ein Rahmen ausgebildet, wobei die erfindungsgemäße Leistungsbaugruppe 4 zumindest an den Tragelementen 6 lastübertragend abgestützt wird.

Aus Fig. 1 ist weiters ersichtlich, dass jede Leistungsbaugruppe 4 eine Mehrzahl von Anschlüssen, wie etwa Stromanschlüsse 32, Steueranschlüsse 33 sowie Kühlmittelanschlüsse 34 aufweisen kann. Diese Anschlüsse liegen vorteilhafterweise in Vertikalrichtung 12 fluchtend zueinander ausgerichtet. Durch die Anordnung der Anschlüsse an der Frontseite 24 ist eine gute Zugänglichkeit für einen Bediener möglich. Die dargestellten Ausführungsbeispiele der Leistungsbaugruppen 4 sind in der Ruhestellung 44 dargestellt, wobei jedes der Leistungsbaugruppen 4 erfindungsgemäß mittels, gegenüber der Energiespeicherbreite 21 der Energiespeicherbaugruppe 9 hervorragenden, Stützflächen 16 auf dem Gestell 2 an den Tragelementen 6 abgestützt ist. Für einen Wechsel einer Leistungsbaugruppe 4 ist es erforderlich, die Leistungsbaugruppe 4 in Vertikalrichtung 12 in eine Servicestellung 45 anzuheben und in Längsrichtung 10 aus dem Gestell 2 zu bewegen. In der gewählten Darstellung kann ferner ersehen werden, dass die Leistungsbaugruppen 4 ihre größte Längserstreckung in Längsrichtung 10 aufweisen, welche in diesem Beispiel die Längserstreckung in Querrichtung 11 sowie in Vertikalrichtung 12 deutlich überragt. Auf diese Weise wird eine im Wesentlichen liegende Anordnung der Leistungsbaugruppe 4 auf den Tragelementen 6 gewährleistet. Eine alternative Dimensionierung mit einer größeren Längserstreckung in Querrichtung 11 ist ebenso denkbar, solange die "flache" liegende Anordnung beibehalten wird. In gewissen Fällen kann es vorteilhaft sein, wenn die Kühlplatte 17 in Längsrichtung 10 die Energiespeicherlänge 22 überragt. Dies kann beispielsweise dazu genutzt werden, dass die Kühlplatte 17 in Richtung Rückseite 25 eine zusätzliche Auflagefläche zur Abstützung an einem Querelement 8 bietet.

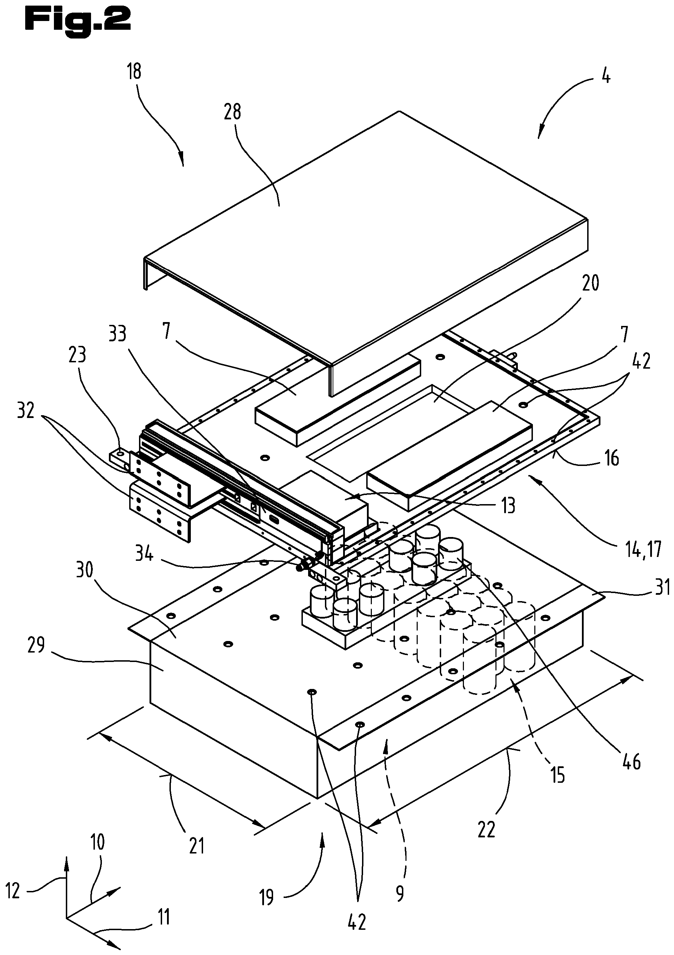

Entsprechend dem Grundkonzept der vorliegenden Erfindung dient die Kühlplatte 17 einerseits zur lastübertragenden Abstützung am Gestell 2 sowie zur Wärmeabfuhr zumindest einer Leistungshalbleiterbaugruppe 7 sowie zumindest einer Energiespeicherbaugruppe 9, welche an einer Ober- 18 respektive Unterseite 19 der Kühlplatte 17 angeordnet sind. Ein Ausführungsbeispiel einer Anordnung der Leistungshalbleiterbaugruppe 7 an der Oberseite 18 der Kühlplatte 17 ist in Fig. 2 schematisch dargestellt. Die zumindest eine Energiespeicherbaugruppe 9 wird an der Unterseite 19 der Kühlplatte 17 angeordnet. Die Energiespeicherbaugruppe 9 kann dabei beispielsweise eine Vielzahl von Kondensatoren 15 aufweisen, wodurch ein hohes Eigengewicht der Energiespeicherbaugruppe 9 von der Kühlplatte 17 getragen werden muss. Die in Fig. 2 in der Explosionsdarstellung gezeigte bevorzugte Ausführungsform bietet den deutlichen Vorteil eines gegenüber den Auflage- bzw. Stützflächen 16 niedriger angeordneten Schwerpunkt der Leistungsbaugruppe 4. Hierdurch kann eine Vermeidung eines unerwünschten Kippmoments in Quer- 11 oder Längsrichtung 10 bei einem Wechsel der Leistungsbaugruppe 4 erzielt werden.

Ferner kann aus Fig. 2 ersehen werden, dass die zumindest eine Leistungshalbleiterbaugruppe 7 mit der Kühlplatte 17 thermisch leitfähig verbunden ist. Die dargestellte im Wesentlichen liegende Anordnung der Leistungshalbleiterbaugruppe 7 auf der Kühlplatte 17 bietet den weiteren Vorteil der Verteilung der Leistungshalbleiter über eine relativ große Auflagefläche an der Oberseite 18 der Kühlplatte 17. Hierdurch in Verbindung mit der direkten thermischen Anbindung an die Kühlplatte 17 kann eine hocheffiziente Wärmeabfuhr der Leistungshalbleiterbaugruppe 7 sichergestellt werden. Die schematisch dargestellte Steuervorrichtung 13 kann ebenfalls an einer geeigneten Position an der Kühlplatte 17 angeordnet sein.

Da erfindungsgemäß die Kühlvorrichtung 14 als von einem Kühlmittel durchströmbare, insbesondere von einer Kühlflüssigkeit durchfließbare, Kühlplatte 17 ausgebildet ist, kann die Kühlplatte 17 als Aufbau bzw. Trägerplattform für die einzelnen Komponenten der Leistungsbaugruppe 4 genutzt werden. Dieser Plattformgedanke kann dazu genutzt werden, Mitteloder Hochspannungsumrichter 1 mittels für den jeweiligen Einsatz optimierten Leistungsbaugruppen 4 auszustatten.

Des Weiteren kann aus Fig. 2 ersehen werden, dass ein Oberseitengehäuse 28 und ein Unterseitengehäuse 29 vorgesehen sind. Diese Gehäuse sind nicht zwingend in alle drei Raumrichtungen geschlossen, jedoch kann es von Vorteil sein, wenn, insbesondere in Querrichtung 11 sowie in Längsrichtung 10, die Seitenflächen zum Explosionsschutz abgeschlossen sind. Es hat sich von Vorteil erwiesen, dass das Ober- 28 oder Unterseitengehäuse 29, welches zur Aufnahme der Energiespeicherbaugruppe 9 vorgesehen ist, ein Deckel- bzw. Bodenelement 30 ausgebildet hat. Im Ausführungsbeispiel von Fig. 2 ist ein derartiges Deckelelement 30 als Abschluss des Unterseitengehäuses 29 in Vertikalrichtung 12 dargestellt. Die vom Unterseitengehäuse 29 aufgenommenen Kondensatoren 15, welche die Energiespeicherbaugruppe 9 bilden, können über elektrische Stromschienen mit der Leistungshalbleiterbaugruppe 7 verbunden werden. Die elektrischen Leiter der Energiespeicherbaugruppe 9 können beispielsweise mittels einem schematisch dargestellten Anschlussterminals 46 zusammengefasst werden. Die zentrale Anordnung eines derartigen Anschlussterminals 46 und der symmetrischen Ausbildung der nicht dargestellten Stromschienen kann zur Vermeidung parasitärer Induktivitäten dienen. Um eine Kontaktierung des Anschlussterminals 46 zur Leistungshalbleiterbaugruppe 7 zu ermöglichen, ist die erfindungsgemäße Kühlplatte 17 mittels zumindest einer Anschlussöffnung 20 in Vertikalrichtung 12 durchbrochen. Die Position der Steuervorrichtung 13 kann vom Fachmann entsprechend optimiert werden, und ist in der beispielhaften Darstellung an der Oberseite 18 der Kühlplatte 17 frontseitig gewählt.

Die Kühlplatte 17 hat aufgrund der lastabtragenden Stützfunktion eine erforderliche Mindeststeifigkeit aufzuweisen, um eine Durchbiegung der Kühlplatte 17 zu vermeiden. Neben der Biegesteifigkeit in Vertikalrichtung 12 kann hierbei die Torsionssteifigkeit um eine gedachte Raumachse von Bedeutung sein. Eine Verwindung der Leistungsbaugruppe 4, und hierbei insbesondere der Kühlplatte 17, sollte beim Zusammenbauen der Leistungsbaugruppe 4 vermieden werden um einen dauerhaften flächigen Kontakt der Leistungshalbleiterbaugruppe 7 zur Kühlplatte 17 zu gewährleisten. Die Kühlplatte 17 kann daher an der Ober- 18 und/oder Unterseite 19 über zusätzliche Versteifungselemente verfügen. Eine Alternative hierzu ist eine erfindungsgemäße Ausnutzung der Eigensteifigkeit, insbesondere der Torsionssteifigkeit, des Oberseitengehäuses 28 und/oder des Unterseitengehäuses 29 zur Erhöhung der Gesamtsteifigkeit, insbesondere der Torsionssteifigkeit, der Leistungsbaugruppe 4. Das Oberseitengehäuse 28 und/oder das Unterseitengehäuse 29 können daher an der Kühlplatte 17 befestigt sein. Eine derartige Befestigung ist sowohl durch Schweißen wie auch bevorzugt durch eine Mehrzahl von Schrauben an dafür vorgesehenen Befestigungsstellen 42 realisiert werden.

In einer bevorzugten Ausführungsform kann die Torsionssteifigkeit des Unterseitengehäuses 29 zur Erhöhung der Torsionssteifigkeit der Leistungsbaugruppe 4 genutzt werden. In diesem in Fig. 2 dargestellten Fall weist das Unterseitengehäuse 29 ein flächig an der Kühlplatte 17 anliegendes Deckelelement 30 auf. Deckelelement 30 ist an einer Mehrzahl von Befestigungsstellen mit der Kühlplatte 17 verbunden. Bevorzugt wird das Deckelelement 30 in Vertikalrichtung 12 durch die Kühlplatte 17 mit dieser verbunden. Diese Befestigungsstellen 42 können somit über die Kühlplatte 17 in Längsrichtung 10 und Querrichtung 11 verteilt sein, wodurch eine großflächige Verbindung der Kühlplatte mit dem Deckelelement 30 gewährleistet ist und eine Spaltbildung vermieden werden kann. Durch diese Maßnahme kann ein ausreichend guter Wärmeübergang der Kühlplatte 17 über das Deckelelement 30 in Richtung Energiespeicherbaugruppe 9 gewährleistet werden. Das Deckelelement 30 wird in einem derartigen Fall als Teil der Kühlplatte 17 verstanden.

In besonderen Fällen kann es vorteilhaft sein, wenn das Unterseitengehäuse 29 und hierbei insbesondere das Deckelelement 30 in Querrichtung 11 Vorsprünge 31 aufweisen. Diese Vorsprünge 31 können einerseits dazu genutzt werden, eine zusätzliche Möglichkeit für Befestigungsstellen 42 auszubilden. Andererseits können derartig in Querrichtung 11 gegenüber der Energiespeicherbreite 21 hervorragende Vorsprünge 31 dazu genutzt werden als eine Art Zwischenelement zur Auflage der Leistungsbaugruppe 4 gegenüber dem Gestell 2 zu dienen. Überdies kann ein derartig an der Kühlplatte 17 befestigtes Unterseitengehäuse 29 die Torsions- und/oder Biegesteifigkeit der Leistungsbaugruppe 4 respektive der Kühlplatte 17 signifikant erhöhen.

In einem nicht dargestellten Fall, können die Vorsprünge 31 soweit gegenüber der Energiespeicherbreite 21 hervorragen, dass sie zur Auflage der Kühlplatte 17 am Gestell 2 dienen. Ebenso ist ein, nicht dargestelltes, Zwischenelement mit der gleichen Funktion, also der Trennung der direkten Auflage der Stützfläche 16 der Kühlplatte 17 vom Gestell 2 denkbar.

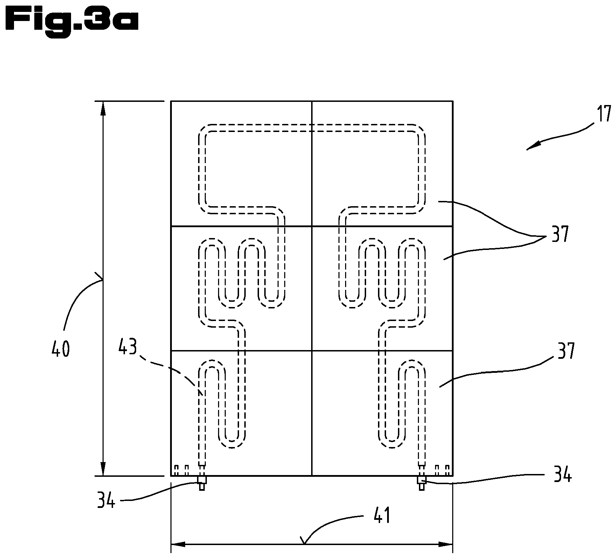

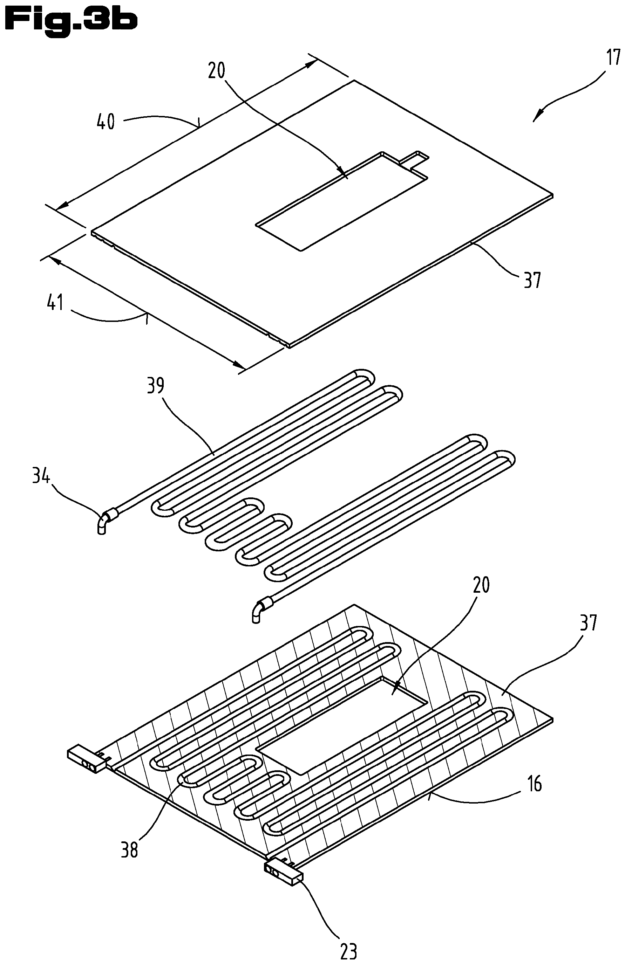

In Fig. 3a und b sind unterschiedliche Ausführungsformen einer Kühlplatte 17 dargestellt. In Fig. 3a kann hierbei ersehen werden, dass die Kühlplatte 17 aus mehreren Kühlplattensegmenten 37 zusammengesetzt sein kann. Die strichlierten Linien stellen einen durchgehend ausgebildeten Kühlkanal 43 dar. Wie besonders gut aus Fig. 3a ersichtlich, können unterschiedliche Kühlplattensegmente 37 unterschiedliche Kühlleistungen aufweisen. Schematisch wird dies durch den mäanderförmig angeordneten Kühlkanal 43 mit einer unterschiedlichen Anzahl an Kühlkanalwindungen in den unterschiedlichen Kühlplattensegmenten 37 angedeutet. Eine Kühlplatte 17 kann somit einfach durch Verbindung mehrerer Kühlplattensegmente 37 an lokal erforderliche Wärmeabfuhrbedingungen adaptiert werden. Es ist somit auf einfache Weise möglich, eine einteilige Kühlplatte 17 aus zumindest zwei Kühlplattensegmenten 37 zusammenzusetzen, welche in Längsrichtung 10 und/oder Querrichtung 11 und/oder Vertikalrichtung 12 geteilt hergestellt wurden.

In einer besonderen Ausführungsform kann es vorteilhaft sein, wenn ein Kühlplattensegment 37 oder auch eine ganze Kühlplatte 17 in Längsrichtung 10 geteilt vorliegt und zumindest eines der Kühlplattensegmente 37 eine Kühlkanalausnehmung 38 aufweist. Siehe hierzu insbesondere Fig. 3b. Eine derartige Kühlkanalausnehmung 38 kann beispielsweise eingefräst werden und bietet Platz für eine Kühlmittelleitung 39, welche in zusammengebauten Zustand der Kühlplatte 17 vollständig von der Kühlplatte 17 eingeschlossen ist.

Eine derartige einfache und modulare Bauweise der Kühlplatte 17 bietet besondere Vorteile hinsichtlich des Plattformgedankens im Zusammenhang mit der lastübertragenen Funktion der Kühlplatte 17.

Ferner kann aus Fig. 3b in Zusammenschau mit Fig. 1 und 2 sowie Fig. 5 die Ausbildung von Anschlagelementen 23 an der Kühlplatte 17 ersehen werden. Derartige Anschlagelemente 23 sind in Querrichtung 11 über die Kühlplattenbreite 41 hervorragend ausgebildet. Sie können dazu verwendet werden, die Leistungsbaugruppe 4 einfach, schnell und korrekt innerhalb des Gestells 2 beim Einführen in der Servicestellung 45 zu positionieren.

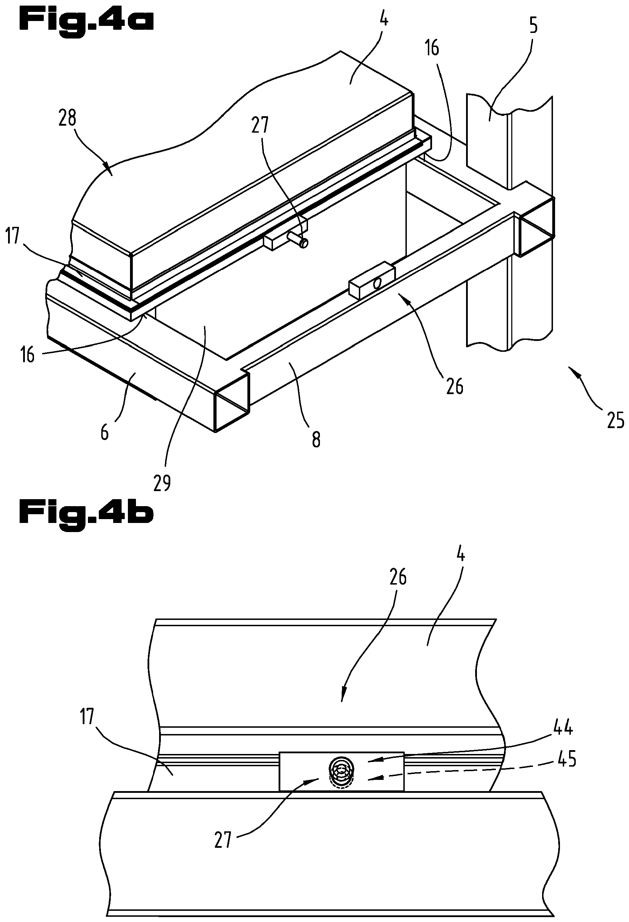

Eine weitere Möglichkeit eines Tiefenanschlags in Kombination mit einer Arretierfunktion wird in Fig. 4 beispielhaft dargestellt. In Fig. 4a ist eine schematische Darstellung einer Koppelvorrichtung 26 am Gestell 2 ersichtlich. Eine derartige Koppelvorrichtung 26 kann beispielsweise als Lasche oder als blockartiges Element ausgeführt sein, wobei vorteilhafterweise eine Längsöffnung zur Aufnahme des korrespondierenden Rückhalteelements 27 der Kühlplatte 17 ausgebildet sein kann. Das Rückhalteelement 27 ist dabei bevorzugt als Stift oder Bolzen mit einer Verjüngung in Querrichtung 11 ausgebildet, welcher in der Servicestellung 45, also im angehobenen Zustand der Leistungsbaugruppe 4 beim Einführen in das Gestell mit der Koppelvorrichtung 26 verbunden wird. Der Stift oder Bolzen weist bevorzugt eine und/oder einen gegenüber dem Stiftdurchmesser verbreiterten Kopf auf, welcher durch die Koppelvorrichtung 26 zumindest einseitig in Vertikalrichtung 12 von unten beim Absenken arretiert wird. Die Funktionsweise wird anhand Fig. 4b schematisch dargestellt. In dieser rückseitigen Ansicht ist die Ruhestellung 44 strichliert angedeutet. Beim Absenken der Leistungsbaugruppe 4 von der Servicestellung 45 in die Ruhestellung 44 wird das Rückhalteelement 27 in der Koppelvorrichtung 26 arretiert. Das freie Ende des Kegelstifts oder Bolzens des Rückhalteelements 27 kann gegenüber der Aufnahmeöffnung der Koppelvorrichtung 26 durch die Verjüngung oder eine hervorragende Erhebung derart gestaltet sein, dass es von der Koppelvorrichtung 26 beim Absenken fixiert ist. Diese Maßnahme verhindert ein Herausrutschen der Leistungsbaugruppe 4 durch externe Schwingungen, wie sie beispielsweise in einem Erdbebenfall auftreten können. Zudem erlaubt die Ausführung der Koppelvorrichtung 26 sowie des an der Kühlplatte 17 ausgebildeten Rückhalteelements 27 eine Selbstzentrierfunktion der Leistungsbaugruppe 4 innerhalb des Aufnahmeraums 3 des Gestells 2.

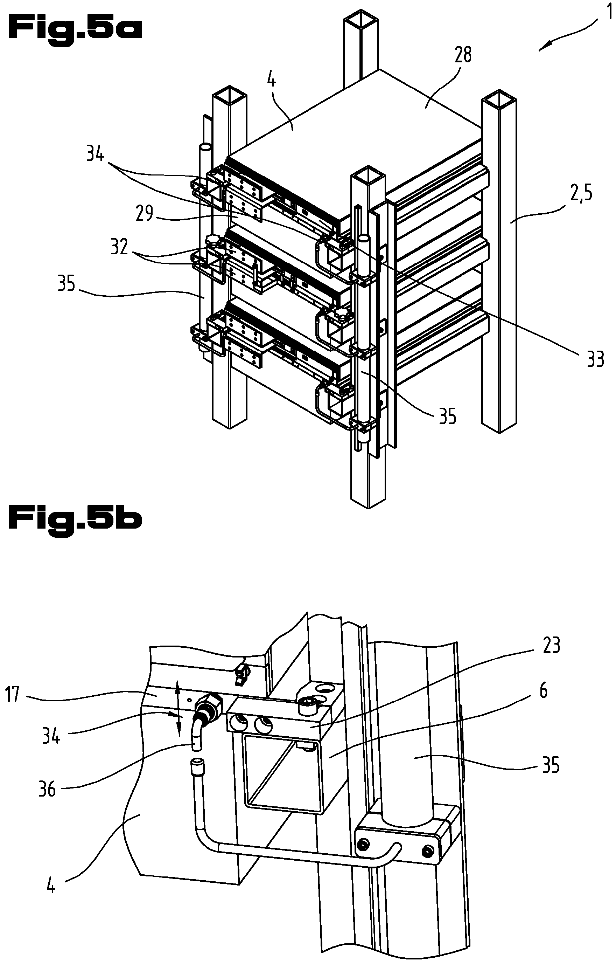

In Fig. 5 ist eine weitere und gegebenenfalls für sich eigenständige Ausführungsform der erfindungsgemäßen Kühlplatte 17 bzw. der Leistungsbaugruppe 4 dargestellt. Auf eine Wiederholung der Beschreibung gleicher Teile wird unter Bezugnahme auf die zuvor beschriebenen Fig. 1 bis 4 verwiesen. In Fig. 5a ist eine Anordnung mehrerer Leistungsbaugruppen 4 in einem Gestell 2 dargestellt, wobei die Leistungsbaugruppen 4 mittels ihrer Kühlmittelanschlüsse 34 an einen Kühlmittelkreislauf 35 des Mittel- oder Hochspannungsumrichters 1 angeschlossen sind. Analog zu den zuvor beschriebenen Ausführungsbeispielen sind die Kühlmittelanschlüsse 34 bevorzugt als Schnellverschlüsse ausgebildet. Auf diese Weise kann eine einfache und schnelle Kopplung an den Kühlmittelkreislauf 35 durchgeführt werden. In Fig. 5b ist eine vergrößerte schematische Darstellung eines Kühlmittelanschlusses dargestellt. Hieraus ersichtlich ist, dass der Kühlmittelanschluss 34 einen Anschlussabschnitt 36 aufweist, welcher in Vertikalrichtung 12 nach unten weisend ausgebildet ist. Die korrespondierende Zu- bzw. Ableitung des Kühlmittelkreislaufs 35 ist analog dazu nach oben gebogen. Auf diese Weise kann eine selbsttätige Kopplung des Kühlmittelkreislaufs 35 mit dem Kühlmittelanschluss 34 beim Absenken der Leistungsbaugruppe 4 von der erhöhten Servicestellung 45 in die Ruhestellung 44 erfolgen. Es ist leicht vorstellbar, dass eine automatische Entkopplung beim Anheben in die Servicestellung 45 mittels geeigneter Schnellkupplungen erfolgen kann. Ebenso ist in Fig. 5b besonders gut ersichtlich, dass das Anschlagelement 23 zur korrekten Positionierung der Leistungsbaugruppe 4 in Längsrichtung 10 ebenfalls eine korrekte Positionierung des Kühlmittelanschlusses 34 gegenüber dem Kühlmittelkreislauf 35 sicherstellt.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist.

Der Schutzbereich ist durch die Ansprüche bestimmt. Die Beschreibung und die Zeichnungen sind jedoch zur Auslegung der Ansprüche heranzuziehen..

Der Ordnung halber sei abschließend darauf hingewiesen, dass zum besseren Verständnis des Aufbaus Elemente teilweise unmaßstäblich und/oder vergrößert und/oder verkleinert dargestellt wurden.

### Bezugszeichenaufstellung

| | | | |
|---|---|---|---|
| 1 | Mittel- oder Hochspannungsum- richter | 30 | Deckelelement |
| | | 31 | Vorsprung |
| 2 | Gestell | 32 | Stromanschluss/-schlüsse |
| 3 | Aufnahmeraum | 33 | Steueranschlluss/-schlüsse |
| 4 | Leistungsbaugruppel | 34 | Kühlmittelanschlluss/-schlüsse |
| 5 | Vertikalstehelement | 35 | Kühlmittelkreislauf |
| 6 | Tragelement | 36 | Anschlussabschnitt |
| 7 | Leistungshalbleiterbaugruppe | 37 | Kühlplattensegment |
| 8 | Querelement | 38 | Kühlkanalausnehmung |
| 9 | Energiespeicherbaugruppe | 39 | Kühlmittelleitung |
| 10 | Längsrichtung | 40 | Kühlplattenlänge |
| 11 | Querrichtung | 41 | Kühlplattenbreite |
| 12 | Vertikalrichtung | 42 | Befestigungsstelle |
| 13 | Steuervorrichtung | 43 | Kühlkanal |
| 14 | Kühlvorrichtung | 44 | Ruhestellung |
| 15 | Kondensator | 45 | Servicestellung |
| 16 | Stützfläche | 46 | Anschlussterminal |
| 17 | Kühlplatte | | |
| 18 | Oberseite | | |
| 19 | Unterseite | | |
| 20 | Anschlussöffnung | | |
| 21 | Energiespeicherbreite | | |
| 22 | Energiespeicherlänge | | |
| 23 | Anschlagelement | | |
| 24 | Frontseite | | |
| 25 | Rückseite | | |
| 26 | Koppelvorrichtung | | |
| 27 | Rückhalteelement | | |
| 28 | Oberseitengehäuse | | |
| 29 | Unterseitengehäuse | | |

## Patentansprüche

1. Leistungsbaugruppe (4) für einen Mittel- oder Hochspannungsumrichter (1), vorzugsweise einen Modularen Multilevel Umrichter, umfassend,
- zumindest eine Leistungshalbleiterbaugruppe (7), vorzugsweise eine IGBT-Baugruppe,
- zumindest eine Energiespeicherbaugruppe (9), vorzugsweise eine Kondensatorbaugruppe,
- zumindest eine Kühlvorrichtung (14), welche Kühlvorrichtung (14) als, von einem Kühlmittel durchströmbare, insbesondere einer Kühlflüssigkeit durchfließbare, Kühlplatte (17) ausgebildet ist, und
- wobei die zumindest eine Leistungshalbleiterbaugruppe (7) mit der Kühlplatte (17) thermisch leitfähig verbunden ist, wobei
- an einer Oberseite (18) der Kühlplatte (17) die zumindest eine Leistungshalbleiterbaugruppe (7) und an einer Unterseite (19) der Kühlplatte (17) die zumindest eine Energiespeicherbaugruppe (9) angeordnet sind, wobei
- die Leistungsbaugruppe (4) zumindest ein Oberseitengehäuse (28) zur Aufnahme der Leistungshalbleiterbaugruppe (7) und/oder einer Steuervorrichtung (13) und zumindest ein Unterseitengehäuse (29) zur Aufnahme der Energiespeicherbaugruppe (9) aufweist, welche mit der Kühlplatte (17) befestigbar, bevorzugt koppelbar, ausgebildet sind, und
- wobei die Kühlplatte (17) zur lastübertragenden Abstützung auf einem Gestell (2) eines zugeordneten Aufnahmeraums (3) des Mittel- oder Hochspannungsumrichters (1) vorgesehen ist, wenn die Leistungsbaugruppe (4) in Bezug auf eine Längsrichtung (10) in den Aufnahmeraum (3) des Gestells (2) eingeschoben ist, und wobei die Kühlplatte (17) seitlich in Quernchtung (11) zur Längsrichtung (10) gegenüber zumindest einer Energiespeicherbreite (21) der Energiespeicherbaugruppe (9) hervorragende Stützflächen (16) aufweist,
- und wobei die Kühlplatte (17) zumindest eine Anschlussöffnung (20) in Vertikalrichtung (12) zur Durchführung und Kontaktierung von Stromanschlüssen der Energiespeicherbaugruppe (9) zur Leistungshalbleiterbaugruppe (7) und/oder Steuervorrichtung (13) aufweist.

2. Leistungsbaugruppe (4) nach Anspruch 1 **dadurch gekennzeichnet, dass** die Kühlplatte (17) derart ausgebildet ist, dass eine in Längsrichtung (10) verlaufende Kühlplattenlänge (40) im Vergleich zu einer in Querrichtung (11) verlaufenden Kühlplattenbreite (41) ein Verhältnis von 5:1 bis 1:2, insbesondere von 2:1 bis 1:1 aufweist und dabei jeweils größer als eine Leistungsbaugruppenhöhe (4) in Vertikalrichtung (12) ist.

3. Leistungsbaugruppe (4) nach einem der vorhergehenden Ansprüche **dadurch gekennzeichnet, dass** die Kühlplatte (17) in Längsrichtung (10) an einer Rückseite (25) zumindest über einen Teil der Kühlplattenbreite (41) gegenüber einer Energiespeicherlänge (22) hervorragend ausgebildet ist.

4. Leistungsbaugruppe (4) nach einem der vorhergehenden Ansprüche **dadurch gekennzeichnet, dass** an der Kühlplatte (17) rückseitig zumindest ein mit einer Koppelvorrichtung (26) des Gestells (2) korrespondierendes, bevorzugt als Stift mit Nut oder Stift mit gegenüber einem Stiftdurchmesser verbreiterten Kopf ausgebildetes, Rückhalteelement (27) angeordnet ist.

5. Leistungsbaugruppe (4) nach Anspruch 1 **dadurch gekennzeichnet, dass** die Torsionssteifigkeit der Kühlplatte (17) um eine horizontale Torsionsachse höher als die Torsionssteifigkeit des Oberseitengehäuses (28) und/oder des Unterseitengehäuses (29) ist.

6. Leistungsbaugruppe (4) nach Anspruch 1 oder 5 **dadurch gekennzeichnet, dass** zumindest das Unterseitengehäuse (29) zur Erhöhung der Torsionssteifigkeit der Leistungsbaugruppe (4) ein an der Kühlplatte (17) flächig anliegendes Deckelelement (30) aufweist, wobei das Unterseitengehäuse (29) mit der Kühlplatte (17) an einer Mehrzahl von Befestigungsstellen (42) verbunden ist.

7. Leistungsbaugruppe (4) nach einem der Ansprüche 1, 5 oder 6 **dadurch gekennzeichnet, dass** das Unterseitengehäuse (29), insbesondere das Deckelelement (30), kühlplattenseitig in Querrichtung relativ zur Energiespeicherbreite (21) hervorragende, insbesondere bis zur Kühlplattenbreite (41) hervorragende, Vorsprünge (31) aufweist.

8. Leistungsbaugruppe (4) nach einem der Ansprüche 1, 5, 6 oder 7 **dadurch gekennzeichnet, dass** an der Stützfläche (16) der Kühlplatte (17) und/oder des Unterseitengehäuses (29) gegenüber dem Gestell (2) des Mittel- oder Hochspannungsumrichters (1) ein, vorzugsweise aus einem vom Material der Kühlplatte (17) und/oder des Unterseitengehäuses (29) abweichendem Material hergestelltes, Zwischenelement vorgesehen ist.

9. Leistungsbaugruppe (4) nach einem der vorhergehenden Ansprüche **dadurch gekennzeichnet, dass** jeweils zumindest zwei Stromanschlüsse (32) und/oder Steueranschlüsse (33) und/oder, bevorzugt als Schnellverschlüsse ausgebildete, Kühlmittelanschlüsse (34) und/oder etwaige Mess- bzw. Hilfsanschlüsse an einer Frontseite (24) der Leistungsbaugruppe (4) ausgebildet sind.

10. Leistungsbaugruppe (4) nach Anspruch 9 **dadurch gekennzeichnet, dass** die Kühlmittelanschlüsse (34) derart ausgebildet sind, dass jeweils zumindest ein Anschlussabschnitt (36) in Vertikalrichtung (12) nach unten weisend ausgebildet ist.

11. Leistungsbaugruppe (4) nach einem der vorhergehenden Ansprüche **dadurch gekennzeichnet, dass** an der Stirnseite der Kühlplatte (17) in Querrichtung (11) über die Kühlplattenbreite (41) zumindest ein hervorragendes Anschlagelement (23) angeordnet ist.

12. Leistungsbaugruppe (4) nach einem der vorhergehenden Ansprüche **dadurch gekennzeichnet, dass** die Kühlplatte (17) aus zumindest zwei in Längsrichtung (10) und/oder Querrichtung (11) und/oder Vertikalrichtung (12) geteilten, Kühlplattensegmenten (37) zur Ausbildung eines durchgehenden Kühlkanals (43) zusammengesetzt ist.

13. Leistungsbaugruppe (4) nach Anspruch 12 **dadurch gekennzeichnet, dass** zumindest zwei Kühlplattensegmente (37) voneinander unterschiedliche Kühlleistungen aufweisen.

14. Leistungsbaugruppe (4) nach einem der Ansprüche 12 oder 13 **dadurch gekennzeichnet, dass** zumindest ein Kühlplattensegment (37), zur Ausbildung eines durchgehenden Kühlkanals (43) in zusammengesetztem Zustand der Kühlplatte (17), eine Kühlkanalausnehmung (38) zur Aufnahme einer formkomplementären Kühlmittelleitung (39) aufweist, welche in zusammengesetztem Zustand der Kühlplatte (17) von der Kühlplatte (17) eingeschlossen ist.

## Claims

1. A power module (4) for a medium or high voltage converter (1), preferably a modular multilevel converter, comprising
- at least one power semiconductor module (7), preferably an IGBT assembly,
- at least one energy storage module (9), preferably a capacitor module,
- at least one cooling device (14), which cooling device (14) is formed as a cooling plate (17) that can be run through by a coolant, in particular flown through by a cooling liquid, and
- wherein the at least one power semiconductor module (7) is connected with the cooling plate (17) in a thermally conductive manner, wherein
- the at least one power semiconductor module (7) is arranged on an upper side (18) of the cooling plate (17) and the at least one energy storage module (9) is arranged on a bottom side (19) of the cooling plate (17), wherein
- the power module (4) comprises at least one upper-side housing (28) for receiving the power semiconductor module (7) and/or a controller (13) and at least one bottom-side housing (29) for receiving the energy storage module (9), formed such that they can be mounted on, preferably be coupled to, the cooling plate (17), and
- wherein the cooling plate (17) is provided for load-bearing support on a rack (2) of an assigned receiving space (3) of the medium or high voltage converter (1) when the power module (4) is inserted into the receiving space (3) of the rack (2) with respect to a longitudinal direction (10), and wherein the cooling plate (17) comprises support surfaces (16) projecting laterally in the transverse direction (11) to the longitudinal direction (10) with respect to at least one energy storage width (21) of the energy storage module (9),
- and wherein the cooling plate (17) comprises at least one connection opening (20) in the vertical direction (12) for leading through and contacting electrical connections of the energy storage module (9) to the power semiconductor module (7) and/or the controller (13).

2. The power module (4) according to claim 1, **characterized in that** the cooling plate (17) is configured such that a cooling plate length (40) in the longitudinal direction (10) to the cooling plate width (41) in the transverse direction (11) has a ratio of 5:1 to 1:2, in particular of 2:1 to 1:1, and is in each case larger than a power module height (4) in the vertical direction (12).

3. The power module (4) according to one of the preceding claims, **characterized in that** the cooling plate (17) in the longitudinal direction (10) on a rear side (25) is formed to project at least beyond a part of the cooling plate width (41) in relation to an energy storage length (22).

4. The power module (4) according to one of the preceding claims, **characterized in that** at least one retaining element (27) corresponding to a coupling device (26) of the rack (2), preferably in the form of a pin with a groove or of a pin with a head that is wider than the pin diameter, is arranged on the rear side of the cooling plate (17).

5. The power module (4) according to claim 1, **characterized in that** the torsional stiffness of the cooling plate (17) about a horizontal torsional axis is higher than the torsional stiffness of the upper-side housing (28) and/or the bottom-side housing (29).

6. The power module (4) according to claim 1 or 5, **characterized in that** at least the bottom-side housing (29), for increasing the torsional stiffness of the power module (4), comprises a cover element (30) resting flat on the cooling plate (17), wherein the bottom-side housing (29) is connected to the cooling plate (17) at a plurality of attachment points (42).

7. The power module (4) according to one of claims 1, 5 or 6, **characterized in that** the bottom-side housing (29), in particular the cover element (30), on the side of the cooling plate in the transverse direction relative to the energy storage width (21) comprises protruding projections (31), in particular protruding up to the cooling plate width (41).

8. The power module (4) according to one of claims 1, 5, 6 or 7, **characterized in that** an intermediate element, preferably made of a material different from the material of the cooling plate (17) and/or the bottom-side housing (29), is provided on the supporting surface (16) of the cooling plate (17) and/or the bottom-side housing (29) opposite the rack (2) of the medium or high voltage converter (1).

9. The power module (4) according to one of the preceding claims, **characterized in that** in each case at least two electrical connections (32) and/or control connections (33) and/or coolant connections (34), preferably formed as quick-release connectors, and/or possible measuring connections and/or auxiliary connections are formed on a front side (24) of the power module (4).

10. The power module (4) according to claim 9, **characterized in that** the coolant connections (34) are configured such that in each case at least one connecting section (36) is formed to point downwards in the vertical direction (12).

11. The power module (4) according to one of the preceding claims, **characterized in that** at least one stop element (23) projecting beyond the cooling plate width (41) is arranged on the end face of the cooling plate (17) in the transverse direction (11).

12. The power module (4) according to one of the preceding claims, **characterized in that** the cooling plate (17) is assembled of at least two cooling plate segments (37) divided in the longitudinal direction (10) and/or the transverse direction (11) and/or the vertical direction (12), for the formation of a continuous coolant channel (43).

13. The power module (4) according to claim 12, **characterized in that** at least two cooling plate segments (37) have different cooling capacities.

14. The power module (4) according to one of claims 12 or 13, **characterized in that** at least one cooling plate segment (37), for the formation of a continuous coolant channel (43) in the assembled state of the cooling plate (17), comprises a coolant channel recess (38) for receiving a coolant line (39) complementary in shape, which is enclosed by the cooling plate (17) in the assembled state of the cooling plate (17).

## Revendications

1. Module de puissance (4) pour un convertisseur moyenne et haute tension (1), de préférence un convertisseur modulaire multi-niveau, comprenant
- au moins un module semi-conducteur de puissance (7), de préférence un module IGBT,
- au moins un module accumulateur d'énergie (9), de préférence un module de condensateur,
- au moins un dispositif de refroidissement (14), ce dispositif de refroidissement (14) étant conçu comme une plaque de refroidissement (17) pouvant être traversé par un fluide de refroidissement, plus particulièrement un liquide de refroidissement et
- dans lequel l'au moins un module semi-conducteur de puissance (7) est relié avec la plaque de refroidissement (17) de manière thermoconductrice, dans lequel
- sur un côté supérieur (18) de la plaque de refroidissement (17), est disposé l'au moins un module semi-conducteur de puissance (7) et sur un côté inférieur (19) de la plaque de refroidissement (17), est disposé le module accumulateur d'énergie (9), dans lequel
- le module de puissance (4) comprend au moins un boîtier supérieur (28) pour le logement du module semi-conducteur de puissance (7) et/ou d'un dispositif de commande (13) et comprend au moins un boîtier inférieur (29) pour le logement du module accumulateur d'énergie (9), qui peut être fixé, de préférence couplé, avec la plaque de refroidissement (17) et
- dans lequel la plaque de refroidissement (17) est prévue pour un appui avec transfert de charge sur un châssis (2) d'un espace de logement (3) correspondant du convertisseur moyenne et haute tension (1) lorsque le module de puissance (4) est introduit, par rapport à une direction longitudinale (10), dans l'espace de logement (3) du châssis (2), et dans lequel la plaque de refroidissement (17) présente des surfaces d'appui (16) dépassant latéralement dans la direction transversale (11) par rapport à la direction longitudinale (10) d'au moins une largeur d'accumulateur d'énergie (21) du module accumulateur d'énergie (9),
- et dans lequel la plaque de refroidissement (17) comprend au moins une ouverture de raccordement (20) dans la direction verticale (12) pour le passage et la mise en contact de bornes électriques du module accumulateur d'énergie (9) avec le module semi-conducteur de puissance (7) et/ou le dispositif de commande (13).

2. Module de puissance (4) selon la revendication 1, **caractérisé en ce que** la plaque de refroidissement (17) est conçue de sorte qu'une longueur de plaque de refroidissement (40) s'étendant dans la direction longitudinale (10) présente, par rapport à une largeur de plaque de refroidissement (41) s'étendant dans une direction transversale (11), un rapport de 5:1 à 1:2, plus particulièrement de 2:1 à 1:1 et est ainsi supérieure à une hauteur de module de puissance (4) dans la direction verticale (12).

3. Module de puissance (4) selon l'une des revendications précédentes, **caractérisé en ce que** la plaque de refroidissement (17) est conçue de façon à dépasser, dans la direction longitudinale (10), au niveau d'un côté arrière (25), d'au moins une partie de la largeur de plaque de refroidissement (41) par rapport à une longueur d'accumulateur d'énergie (22).

4. Module de puissance (4) selon l'une des revendications précédentes, **caractérisé en ce que**, sur la plaque de refroidissement (17), à l'arrière, est disposé au moins un élément de retenue (27) correspondant avec un dispositif de couplage (26) du châssis (2), de préférence conçu comme une tige avec une rainure ou une tige avec une tête élargie par rapport à un diamètre de tige.

5. Module de puissance (4) selon la revendication 1, **caractérisé en ce que** la résistance à la torsion de la plaque de refroidissement (17) autour d'un axe de torsion est supérieure à la résistance à la torsion du boîtier supérieur (28) et/ou du boîtier inférieur (29).

6. Module de puissance (4) selon la revendication 1 ou 5, **caractérisé en ce qu'**au moins le boîtier inférieur (29) présente, afin d'augmenter la résistance à la torsion du module de puissance (4), un élément de couvercle (30) s'appuyant à plat contre la plaque de refroidissement (17), dans lequel le boîtier inférieur (29) est relié avec la plaque de refroidissement (17) au niveau d'une pluralité de points de fixation (42).

7. Module de puissance (4) selon l'une des revendications 1, 5 ou 6, **caractérisé en ce que** le boîtier inférieur (29), plus particulièrement l'élément de couvercle (30) présente, du côté de la plaque de refroidissement, des saillies (31) dans la direction transversale par rapport à la largeur d'accumulateur d'énergie (21), plus particulièrement dépassant jusqu'à la largeur de plaque de refroidissement (41).

8. Module de puissance (4) selon l'une des revendications 1, 5, 6 ou 7, **caractérisé en ce que**, sur la surface d'appui (16) à de la plaque de refroidissement (17) et/ou du boîtier inférieur (29), en face du châssis (2) du convertisseur moyenne ou haute tension (1), est prévu un élément intermédiaire constitué de préférence d'un matériau différent du matériau de la plaque de refroidissement (17) et/ou du boîtier inférieur (29).

9. Module de puissance (4) selon l'une des revendications précédentes, **caractérisé en ce qu'**au moins deux bornes électriques (32) et/ou bornes de commande (33) et/ou des raccords de fluides de refroidissement (34), conçus comme des raccords rapides, et/ou des raccords de mesure ou auxiliaires sont prévus sur une face frontale (24) du module de puissance (4).

10. Module de puissance (4) selon la revendication 9, **caractérisé en ce que** les raccords de fluides de refroidissement (34) sont conçus de sorte qu'au moins une portion du raccord (36) est orientée dans la direction verticale (12) vers le bas.

11. Module de puissance (4) selon l'une des revendications précédentes, **caractérisé en ce que**, sur la face frontale de la plaque de refroidissement (17) est disposé au moins un élément de butée (23) dépassant dans la direction transversale (11) de la largeur de plaque de refroidissement (41).

12. Module de puissance (4) selon l'une des revendications précédentes, **caractérisé en ce que** la plaque de refroidissement (17) est constituée d'au moins deux segments de plaque de refroidissement (37) divisés dans la direction longitudinale (10) et/ou dans la direction transversale (11) et/ou dans la direction verticale (12), afin de former un canal de refroidissement (43) continu.

13. Module de puissance (4) selon la revendication 12, **caractérisé en ce qu'**au moins deux segments de plaque de refroidissement (37) présentent des puissances de refroidissement différentes entre elles.

14. Module de puissance (4) selon l'une des revendications 12 ou 13, **caractérisé en ce qu'**au moins un segment de plaque de refroidissement (37), pour former un canal de refroidissement (43) continu dans l'état assemblé de la plaque de refroidissement (17), comprend un évidement de canal de refroidissement (38) pour le logement d'une conduite de fluide de refroidissement (39) de forme complémentaire, qui est intégrée, dans l'état assemblé de la plaque de refroidissement (17), par la plaque de refroidissement (17).
